Europäisches Patentamt

European Patent Office

Office européen des brevets

(11) Veröffentlichungsnummer: **0 142 182 B1**

(12) **EUROPÄISCHE PATENTSCHRIFT**

(45) Veröffentlichungstag der Patentschrift: **24.04.91**

(51) Int. Cl.5: **H03M 1/74**

(21) Anmeldenummer: **84201304.7**

(22) Anmeldetag: **11.09.84**

(54) Schaltungsanordnung zum Umwandeln eines digitalen Eingangssignals in ein analoges Ausgangssignal.

(30) Priorität: **14.09.83 DE 3333067**

(43) Veröffentlichungstag der Anmeldung:
**22.05.85 Patentblatt 85/21**

(45) Bekanntmachung des Hinweises auf die
Patenterteilung:
**24.04.91 Patentblatt 91/17**

(84) Benannte Vertragsstaaten:
**DE FR GB IT**

(56) Entgegenhaltungen:
**EP-A- 0 123 222**
**DE-A- 3 126 084**
**GB-A- 2 093 298**

(73) Patentinhaber: **Philips Patentverwaltung GmbH**
**Wendenstrasse 35 Postfach 10 51 49**
**W-2000 Hamburg 1(DE)DE**

Patentinhaber: **N.V. Philips' Gloeilampenfabrieken**
**Groenewoudseweg 1**
**NL-5621 BA Eindhoven(NL)FR GB IT**

(72) Erfinder: **Demmer, Walter Heinrich**
**Sortmannweg 15**
**W-2000 Hamburg 54(DE)**

(74) Vertreter: **Hartmann, Heinrich, Dipl.-Ing. et al**
**Philips Patentverwaltung GmbH Wendenstrasse 35 Postfach 10 51 49**
**W-2000 Hamburg 1(DE)**

## Beschreibung

Die Erfindung bezieht sich auf eine Schaltungsanordnung zum Umwandeln eines digitalen Eingangssignals in ein analoges Ausgangssignal mit einer Spannungsteilerkette, die zwischen ihren von wenigstens einer Referenzspannungsquelle gespeisten Enden eine Anzahl von Abgriffen aufweist, die, gesteuert durch das digitale Eingangssignal, mit einem Ausgang zum Ableiten des analogen Ausgangssignals verbindbar sind.

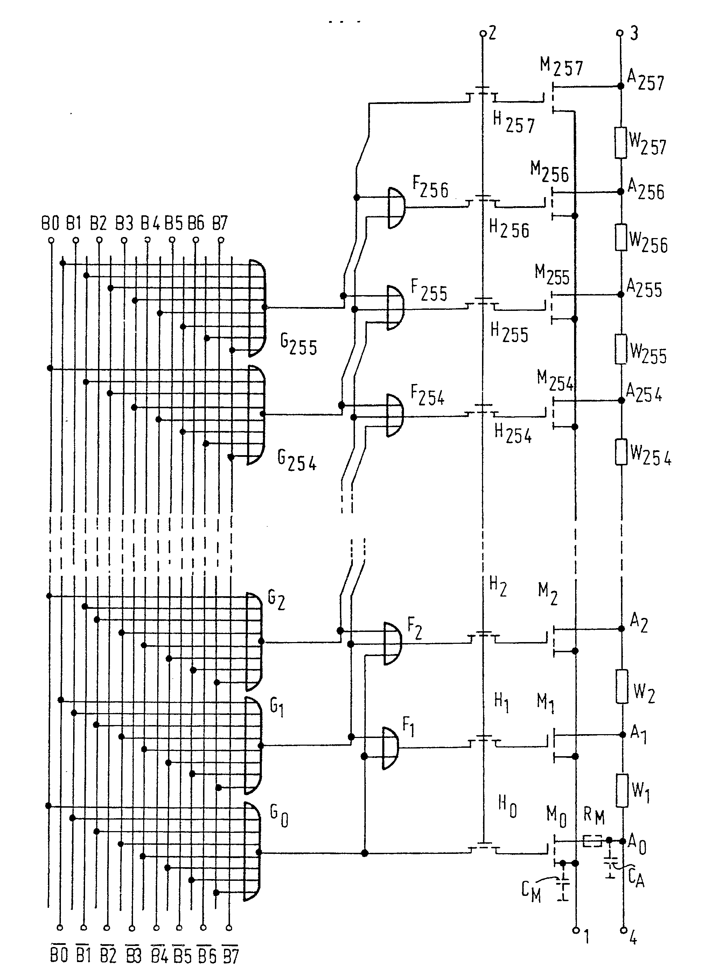

Aus der DE-OS 31 26 084, insbesondere Fig. 3 mit zugehöriger Beschreibung, ist ein Digital-Analog-Wandler bekannt, bei dem eine Menge von Analog-Werten durch einen aus einer Reihenschaltung einer Anzahl von Widerständen gebildeten Spannungsteiler geliefert wird. Die Abschnitte dieses Spannungsteilers sind mit je einer Eingangselektrode eines zugeordneten Schalter-Transistors verbunden. Die Ausgangselektroden der Schalter-Transistoren sind gemeinsam mit dem Analogausgang verbunden. Der Wandler weist ferner eine der Anzahl der Schalter-Transistoren entsprechende Anzahl von NOR-Gattern auf, deren Eingängen ein digitales Eingangssignal aus mehreren parallelen Bits zugeführt wird. Für jeden digitalen Wert des digitalen Eingangssignals liefert jeweils nur eines der NOR-Gatter einen Ausgangswert "1". Die Ausgänge der NOR-Gatter sind mit den Steuerelektroden von je einem Schalter-Transistor verbunden. Je nach dem zugeführten digitalen Eingangssignal wird nur einer der Schalter-Transistoren durchlässig, und der entsprechende Analogwert tritt am Ausgang auf.

Derartige Digital-Analog-Wandler zeichnen sich durch hohe Linearität der Wandlerkennlinie und ein von Störungen, insbesondere sogenannten Ausreißern (Glitches), freies analoges Signal aus.

Bei der beschriebenen Schaltungsanordnung nach dem Stand der Technik wird das dem Spannungsteiler entnommene analoge Ausgangssignal über jeweils einen Schalter-Transistor dem Ausgang zugeführt. Diese Schalter-Transistoren haben an ihren Eingangs- und Ausgangselektroden parasitäre Kapazitäten, insbesondere gegenüber dem Massepotential, sowie einen endlichen Übergangswiderstand zwischen ihrer Eingangs- und ihrer Ausgangselektrode. Insbesondere bei der anzustrebenden Integration der gesamten Schaltungsanordnung auf einem Halbleiterplättchen und den dafür nötigen geringen Abmessungen der Schalter-Transistoren können die Übergangswiderstände derartige Werte annehmen, daß das analoge Ausgangssignal nur extrem hochohmig weitergeleitet werden kann, um parasitäre Spannungsabfälle unterhalb der Auflösungsgrenze des analogen Ausgangssignals zu halten. Darüber hinaus bilden die Kapazitäten der Ausgangselektroden mit den Übergangswiderständen eine Tiefpaßanordnung, durch die der Bereich der von der Schaltungsanordnung übertragbaren Signalfrequenzen stark eingeschränkt wird.

Die Erfindung hat die Aufgabe, eine Schaltungsanordnung der eingangs genannten Art zum Umwandeln eines digitalen Eingangssignals in ein analoges Ausgangssignal zu schaffen, an deren Ausgang das analoge Ausgangssignal niederohmig abgeleitet werden kann und die eine hohe Grenzfrequenz aufweist.

Diese Aufgabe wird erfindungsgemäß dadurch gelöst, daß bei einer Schaltungsanordnung der eingangs genannten Art jeder mögliche Wert des digitalen Eingangssignals wenigstens zwei Abgriffe der Spannungsteilerkette gemeinsam niederohmig mit dem Ausgang verbindet, wobei dadurch zumindest ein Widerstand der Spannungsteilerkette niederohmig überbrückt wird.

Bei der erfindungsgemäßen Schaltungsanordnung werden somit durch jeden Wert des digitalen Eingangssignals mehrere Verbindungen zwischen dem Ausgang und Abgriffen der Spannungsteilerkette gemeinsam hergestellt. Umgekehrt wird jeder Abgriff der Spannungsteilerkette bei mehreren Werten des digitalen Eingangssignals mit dem Ausgang verbunden. Das bedeutet, daß jeweils mehrere Verbindungen zwischen den Abgriffen der Spannungsteilerkette und dem Ausgang - beispielsweise mehrere Schalter-Transistoren - mit den ihnen eigenen Übergangswiderständen im wesentlichen parallel geschaltet sind. Dadurch wird der gesamte Übergangswiderstand zwischen der Spannungsteilerkette und dem Ausgang für das analoge Ausgangssignal verringert.

Eine reine Verringerung des Übergangswiderstands könnte beispielsweise bei der Verwendung von Schalter-Transistoren in MOS-Technologie allein dadurch erreichbar erscheinen, daß die Abmessungen der Kanäle derartiger Transistoren in entsprechender Weise vergrößert werden. Die damit verbundene Vergrößerung der geometrischen Abmessungen der Transistoren verhindert aber nicht nur ein wünschenswertes Maß der Integration der Schaltungsanordnung auf einem Halbleiterplättchen, sondern erhöht auch die parasitären Kapazitäten der Eingangs- und Ausgangselektroden der Transistoren. Diese Kapazitäten Schränken dann den Bereich der nutzbaren Frequenzen des analogen Ausgangssignals wieder wie vorher ein.

Demgegenüber wird hei der Ausbildung der Schaltungsanordnung nach der Erfindung eine Verringerung des gesamten Übergangswiderstands zwischen der Spannungsteilerkette und dem Ausgang erreicht, ohne daß die parasitären Kapazitäten nennenswert vergrößert werden. Damit ist einerseits eine niederohmige Entnahme des analogen Ausgangssignals und andererseits eine Vergrößerung des Bereichs der nutzbaren Frequenzen des analogen Ausgangssignals erreicht.

Nach einer Fortbildung der Erfindung ist der Ausgang mit wenigstens zwei unmittelbar benachbarten Abgriffen der Spannungsteilerkette verbunden. Wenn zwei zunächst beliebig gewählte Abgriffe der Spannungsteilerkette gemeinsam mit dem Ausgang verbunden werden, wird der zwischen den betreffenden Abgriffen angeordnete Teil der Spannungsteilerkette durch die Verbindungen zwischen den Abgriffen und dem Ausgang überbrückt. Die Anzahl der an der Spannungsteilerkette abgreifbaren Werte des analogen Ausgangssignals wird dadurch um s verringert, wobei s-1 die Anzahl der Abgriffe im überbrückten Teil der Spannungsteilerkette ist. Soll die Anzahl der Werte des analogen Ausgangssignals gleich der Anzahl der Werte des digitalen Eingangssignals unverändert bleiben, muß die Anzahl der Abgriffe der Spannungsteilerkette entsprechend um s erhöht werden. Entsprechend ist die Anzahl der schaltbaren Verbindungen zwischen den Abgriffen und dem Ausgang, d.h. beispielsweise die Zahl der Schalter-Transistoren, zu erhöhen. Durch Überbrücken eines großen Teils der Spannungsteilerkette würde somit ein erhöhter Schaltungsaufwand hervorgerufen werden. Außerdem können dabei durch Toleranzen in den Übergangswiderständen der Verbindungen (z.B. Schalter-Transistoren) Fehler in der Abstufung der Werte des analogen Ausgangssignals entstehen. Es ist daher vorteilhaft, jeweils unmittelbar benachbarte Abgriffe der Spannungsteilerkette mit dem Ausgang zu verbinden.

In einer Ausgestaltung der Erfindung sind die Abgriffe über elektronische Schalter mit dem Ausgang verbindbar. Derartige Schalter sind bevorzugt als MOS-Transistoren ausgeführt. Derartige Schalter benötigen äußerst geringe Steuerleistungen und lassen sich in einfacher Weise herstellen, wodurch eine gute Integrierbarkeit der erfindungsgemäßen Schaltungsanordnung auf einem Halbleiterplättchen erreicht wird.

Nach einer anderen Weiterbildung der Erfindung besteht die Spannungsteilerkette aus einer Anzahl von Elementen, die durch die Summe der Anzahl der möglichen Werte des digitalen Eingangssignals und des größten Abstands der gemeinsam mit dem Ausgang verbundenen Abgriffe der Spannungsteilerkette bestimmt ist. Durch diese Maßnahme wird sichergestellt, daß die Anzahl der einstellbaren Werte des analogen Ausgangssignals stets gleich der Anzahl der möglichen Werte des digitalen Eingangssignals ist.

Nach einer weiteren Ausgestaltung der Erfindung umfaßt die Spannungsteilerkette ohmsche Widerstandselemente. Diese sind einfach und genau herstellbar und gestatten die Verwendung von Gleichstrom- oder Spannungsquellen als Referenzquellen. Dadurch werden parasitäre Impedanzen im Aufbau der Spannungsteilerkette auf einfache Weise unwirksam gemacht.

In einer weiteren Fortbildung enthält die Schaltungsanordnung nach der Erfindung eine logische Auswahlschaltung, die aus dem digitalen Eingangssignal Steuersignale zum Schalten der Verbindungen zwischen den Abgriffen der Spannungsteilerkette und dem Ausgang bildet. Die Auswahlschaltung ist bevorzugt mit der Spannungsteilerkette und den die Abgriffe mit dem Ausgang verbindenden Schaltern auf einem Halbleiterplättchen zusammengefaßt.

Die Erfindung wird im folgenden anhand eines in der Zeichnung dargestellten Ausführungsbeispiels näher erläutert.

Die Figur zeigt als Beispiel für eine erfindungsgemäße Schaltungsanordnung einen 8-Bit-Digital-Analog-Wandler, dem über 8 parallele Bit-Leitungen B0 bis B7 ein digitales Eingangssignal zugeführt wird. Über 8 weitere, parallele Bit-Leitungen $\overline{B0}$ bis $\overline{B7}$ wird der Schaltungsanordnung weiterhin das komplementäre Eingangssignal zugeführt. Die Eingänge für das digitale Eingangssignal und seine komplementäre Form sind in der Figur getrennt dargestellt. Das komplementäre Signal läßt sich jedoch in bekannter Weise mit einfachen Invertern, die der Übersichtlichkeit halber nicht dargestellt sind, aber leicht in die dargestellte Schaltungsanordnung eingefügt werden können, aus dem Eingangssignal gewinnen.

Die Leitungen B0 bis B7 sowie $\overline{B0}$ bis $\overline{B7}$ sind mit Eingängen von 256 NOR-Gattern G0 bis G255 derart verbunden, daß für jeden möglichen Wert des digitalen Eingangssignals jeweils nur eines dieser Gatter an seinem Ausgang einen Ausgangswert "1" liefert. Die Ausgänge dieser Gatter sind mit Eingängen von - in diesem Beispiel - 256 ODER-Gattern F1 bis F256 verbunden. Die Ausgänge dieser ODER-Gatter F1 bis F256 sind jeweils mit einer Eingangselektrode eines von - in diesem Beispiel - 256 Feldeffekttransistoren H1 bis H256 verbunden. Außerdem sind die Ausgänge des ersten und des letzten NOR-Gatters G0 und G255 unmittelbar mit je einer Eingangselektrode eines Feldeffekttransistors H0 bzw. H257 verbunden. Die Ausgangselektroden der Feldeffekttransistoren H0 bis H257 sind mit einer Steuerelektrode je eines Schalter-Transistors M0 bis M257 verbunden. Die Eingangselektroden der Schalter-Transistoren M0 bis M257 sind mit je einem Abgriff A0 bis A257 einer aus Widerständen W1 bis W257 aufgebauten Spannungsteilerkette verbunden. In dieser Spannungsteilerkette ist jeweils einer der Abgriffe A0 bis A257 an je einem der Verbindungspunkte zwischen den Widerständen W1 bis W257 bzw. den Verbindungen der Widerstände W1 bzw. W257 mit zwei Endanschlüssen 3, 4 angeordnet.

Die Steuerelektroden der Feldeffekttransistoren H0 bis H257 sind miteinander und mit einem Takteingang 2 verbunden. Die Verbindungen zwischen den NOR-Gattern G0 bis G255 und den Feldeffekttransistoren H0 bis H257 und damit den Schalter-Transistoren M0 bis M257 sind über die ODER-Gatter F1 bis F256 bzw. unmittelbar derart ausgeführt, daß ein Ausgangswert "1" eines NOR-Gatters je drei einander benachbarte Schalter-Transistoren in den leitenden Zustand schaltet und somit drei benachbarte Abgriffe der Spannungsteilerkette mit dem Ausgang 1 verbindet. Damit tritt der Analogwert, der dem diesen Schaltzustand auslösenden Wert des digitalen Eingangssignals entspricht, am Ausgang 1 auf. Wenn die Übergangswiderstände der Schalter-Transistoren M0 bis M257 untereinander gleich sind, stimmt der Spannungswert des analogen Ausgangssignals mit dem Spannungswert am mittleren der drei mit dem Ausgang 1 verbundenen Abgriffe überein.

Über den Takteingang 2 kann ein Taktsignal zugeführt werden, das sämtliche Schalter-Transistoren M0 bis M257 beispielsweise während des Umschaltens des digitalen Eingangssignals von einem Wert auf einen anderen sperrt. Dadurch lassen sich Störungen im analogen Ausgangssignal unterdrücken.

Die Endanschlüsse 3, 4 der Spannungsteilerkette sind mit den Anschlüssen zweier Referenzgleichspannungsquellen verbunden. Je nach dem gewünschten Aussteuerungsbereich des analogen Ausgangssignals können die Endanschlüsse 3, 4 auf verschiedene, auch negative Spannungspotentiale gelegt oder mit Stromquellen verbunden werden, die in den Widerständen W1 bis T257 entsprechende Spannungsabfälle hervorrufen.

In der Figur sind am Beispiel des Schalter-Transistors M0 die wichtigsten parasitären Elemente eines derartigen Schalter-Transistors dargestellt. Die Kapazität CA ist die parasitäre Kapazität der Eingangselektrode gegenüber dem Massepotential. Da sie unmittelbar mit dem Abgriff A0 der Spannungsteilerkette verbunden ist, liegt an ihr lediglich eine Gleichspannung, so daß die Kapazität CA auf den Verlauf des analogen Ausgangssignals keinen schädlichen Einfluß nimmt.

Der Schalter-Transistor M0 weist ferner zwischen seiner Eingangs- und seiner Ausgangselektrode einen Übergangswiderstand RM auf, der durch den Widerstand des Transistorkanals im leitenden Zustand hervorgerufen wird. Außerdem weist die Ausgangselektrode eine parasitäre Kapazität CM gegenüber dem Massepotential auf. Die parasitären Elemente CA, CM und RM sind entsprechend an allen anderen Schalter-Transistoren M1 bis M257 vorhanden, der Übersichtlichkeit halber jedoch nicht eingezeichnet. Die Kapazitäten CM aller Schalter-Transistoren sind mit dem analogen Ausgangssignal beaufschlagt. Zusammen mit dem Übergangswiderstand eines im leitenden Zustand befindlichen Schalter-Transistors bilden sie einen Tießpaß, dessen Grenzfrequenz eine Verwendung der Schaltungsanordnung bei höheren Frequenzen ausschließt. Durch das gemeinsame Umschalten mehrerer Schalter-Transistoren in den leitenden Zustand läßt sich die Grenzfrequenz des genannten Tiefpasses aus den parasitären Elementen derart erhöhen, daß eine Beeinträchtigung des analogen Ausgangssignals nicht mehr auftritt. Die beschriebene Schaltungsanordnung ist damit auch zum Umsetzen digitaler Signale mit hoher Datenfolgefrequenz, beispielsweise digitaler Video-Signale, einsetzbar.

## Ansprüche

1. Schaltungsanordnung zum Umwandeln eines digitalen Eingangssignals (B0...B7) in ein ana-loges Ausgangssignal mit einer Spannungstei-lerkette (W1...W257), die zwischen ihren von wenigstens einer Referenzquelle gespeisten Enden (3,4) eine Anzahl von Abgriffen (40...4257) aufweist, die, gesteuert durch das digitale Eingangssignal, mit einem Ausgang (1) zum Ableiten des analogen Ausgangssignals verbindbar sind, dadurch gekennzeichnet, daß jeder mögliche Wert des digitalen Eingangssignals (B0...B7) wenigstens zwei Abgriffe (A0...A257) der Span-nungsteilerkette (W1...W257) gemeinsam nie-derohmig mit dem Ausgang verbindet, wobei dadurch zumindest ein Widerstand der Spannungsteilerkette niederohmig überbrückt wird.

2. Schaltungsanordung nach Anspruch 1, dadurch gekennzeichnet, daß der Ausgang (1) mit wenigstens zwei unmittelbar benarchbarten Abgriffen (A0...A257) der Spannungsteilerkette (W1...W257) verbunden ist.

3. Schaltungsanordnung nach Anspruch 1 oder 2, dadurch gekennzeichnet, daß die Abgriffe (A0...A257) über elektronische Schalter (M0...M257) mit dem Ausgang (1) verbindbar sind.

4. Schaltungsanordnung nach Anspruch 3, dadurch gekennzeichnet, daß die elektronischen Schalter (M0...M257) MOS-Transistoren sind.

5. Schaltungsanordnung nach einem der vorhergehenden Ansprüche, dadurch gekennzeichnet, daß die Spannungsteilerkette (W1...W257) aus einer Anzahl von Elementen (W1, W2, ...) besteht, die durch die Summe der Anzahl der möglichen Werte des digitalen Eingangssignals (B0...B7) und des größten Abstandes der gemeinsam mit dem Ausgang (1) verbundenen Abgriffe (A0...A257) der Spannungsteilerkette (W1...W257) bestimmt ist.

6. Schaltungsanordnung nach einem der vorhergehenden Ansprüche,
dadurch gekennzeichnet, daß die Spannungsteilerkette (W1...W257) Ohmsche Widerstandselemente (W1, W2, ...) umfaßt.

7. Schaltungsanordnung nach einem der vorhergehenden Ansprüche,
gekennzeichnet durch eine logische Auswahlschaltung (G0...G255, F1...F256), die aus dem digitalen Eingangssignal Steuersignale zum Schalten der Verbindungen zwischen den Abgriffen (A0...A257) der Spannungsteilerkette (W1...W257) und dem Ausgang (1) bildet.

## Claims

1. A circuit arrangement for converting a digital input signal (B0...B7) into an analog output signal, the arrangement comprising a voltage divider chain (W1...W257) having between its ends (3, 4), which are energized by at least one reference source, a plurality of taps (A0...A257) which can be connected to an input (1) under control of the digital input signal in order to derive the analog output signals, characterized in that for every possible value of the digital input signal (B0...B7) at least two taps (A0...A257) of the voltage divider chain (W1...W257) are jointly connected to the output through a low impedance, as a result of which at least one resistor of the voltage divider chain is bypassed to provide a low-impedance path.

2. A circuit arrangement as claimed in Claim 1, characterized in that the output (1) is connected to at least two directly adjacent taps (A0...A257) of the voltage divider chain (W1...W257).

3. A circuit arrangement as claimed in Claim 1 or 2, characterized in that the taps (A0...A257) can be connected to the output (1) via electronic switches (M0...M257).

4. A circuit arrangement as claimed in Claim 3, characterized in that the electronic switches (M0...M257) are MOS-transistors.

5. A circuit arrangement as claimed in any one of the preceding Claims, characterized in that the voltage divider chain (W1...W257) is formed by a number of elements (W1, W2, ...), which number is given by the sum of the number of possible values of the digital input signal (B0...B7) and the maximal spacing of the taps (A0...A257) of the voltage divider chain (W1...W257) which are jointly connected to the output (1).

6. A circuit arrangement as claimed in any one of the preceding Claims, characterized in that the voltage divider chain (W1...W257) comprises ohmic resistance elements (W1, W2

7. A circuit arrangement as claimed in any one of the preceding Claims, characterized by a logic selection circuit (G0...G255, F1...F256) which derives from the digital input signal control signals for switching the connections between the taps (A0...A257) of the voltage divider chain (W1...W257) and the output (1).

## Revendications

1. Dispositif de circuit pour la conversion d'un signal d'entrée numérique (B0...B7) en un signal de sortie analogique comprenant une chaîne de diviseurs de tension (W1...W257) présentant, entre ses extrémités (3, 4) alimentées par au moins une source de tension de référence, plusieurs prises (A0...A257) qui, commandées par le signal d'entrée numérique, peuvent être connectées à une sortie (1) pour le prélèvement du signal de sortie analogique, caractérisé en ce que chaque valeur possible du signal d'entrée numérique (B0...B7) relie en commun et à basse valeur ohmique au moins deux prises (A0...A257) de la chaîne de diviseurs de tension (W1...W257) à la sortie de façon qu'au moins une résistance de la chaîne de diviseurs de tension soit shuntée à basse valeur ohmique.

2. Dispositif de circuit selon la revendication 1, caractérisé en ce que la sortie (1) est connectée à au moins deux prises immédiatement avoisinantes (A0...A257) de la chaîne de diviseurs de tension (W1...W257).

3. Dispositif de circuit selon la revendication 1 ou 2, caractérisé en ce que les prises (A0...A257) peuvent être connectées à la sortie 1 par l'intermédiaire de commutateurs électroniques (M0...M257).

4.  Dispositif de circuit selon la revendication 3, caractérisé en ce que les commutateurs électroniques M0...M257) sont des transistors MOS.

5.  Dispositif de commutation selon l'une des revendications précédentes, caractérisé en ce que la chaîne de diviseurs de tension (W1...W257) est constituée par plusieurs éléments (W1, W2, ...) dont le nombre est déterminé par la somme du nombre de valeurs possibles du signal d'entrée numérique (B0...B7) et la distance maximale des prises (A0...A257) de la chaîne de diviseurs de tension (W1...W257) reliées en commun à la sortie 1.

6.  Dispositif de circuit selon l'une des revendications précédentes, caractérisé en ce que la chaîne de diviseurs de tension (W1...W257) comprend des éléments de résistance ohmique (W1, W2,...).

7.  Dispositif de circuit selon l'une des revendications précédentes, caractérisé par un circuit de sélection logique (G0...G255, F1.. F256) qui forme à partir du signal d'entrée numérique des signaux de commande pour la commutation des connexions entre les prises (A0...A257) de la chaîne de diviseurs de tension (W1...W257) et la sortie (1).